# FASCICULE DE BREVET EUROPEEN

(11) **EP 1 109 321 B1**
(45) Date de publication et mention de la délivrance du brevet: **29.07.2009**
(21) Numéro de dépôt: 00125557.9
(22) Date de dépôt: 22.11.2000
(51) Int. Cl.: H03M 13/19, G06F 11/10, G11C 29/00

(54) **Procédé de correction d'un bit dans une chaîne de bits**
Einzelbit- Korrekturverfahren in einer Bitkette
One bit error correction method in a chain of bits

(30) Priorité: 15.12.1999 FR 9915816
(43) Date de publication de la demande: 20.06.2001
(73) Titulaire: STMicroelectronics SA, F-92120 Montrouge (FR)
(72) Inventeur: La Rosa, Francesco, 13790 Rousset (FR)
(74) Mandataire: Viering, Jentschura & Partner

(56) Documents cités:
- EP-A- 0 305 987
- EP-A- 0 307 958
- EP-A- 0 399 258
- US-A- 5 671 239
- HAIFLEY T: "ENDURANCE OF EEPROMS WITH ON-CHIP ERROR CORRECTION" IEEE TRANSACTIONS ON RELIABILITY,US,IEEE INC. NEW YORK, vol. 36, no. 2, 1 juin 1987 (1987-06-01), pages 222-223, XP000008989 ISSN: 0018-9529

## Description

La présente invention concerne les mémoires non volatiles, notamment les mémoires programmables et effaçables électriquement du type EEPROM ou FLASH comprenant des cellules mémoire pourvues de transistors à grille flottante.

Dans les mémoires programmables et effaçables électriquement, la valeur d'un bit stocké dans une cellule mémoire est représentée par une caractéristique électrique rémanente de la cellule, qui peut être modifiée à volonté par des opérations d'effacement ou de programmation de la cellule pour l'enregistrement d'un "1" ou d'un "0". Plus particulièrement, la programmation ou l'effacement d'une cellule mémoire comprenant un transistor à grille flottante consiste dans l'injection ou l'extraction de charges électriques dans la grille du transistor, au moyen d'une haute tension de programmation ou d'effacement de l'ordre de 10 à 20 V. Les charges électriques injectées ou extraites de la grille flottante déterminent la tension de seuil Vt du transistor, qui constitue la caractéristique électrique rémanente représentative du bit stocké dans la cellule mémoire.

La lecture d'une cellule mémoire comprenant un transistor à grille flottante consiste ainsi à comparer la tension de seuil Vt du transistor avec une tension de référence Vt₀ qui se trouve sensiblement à mi-chemin entre la tension de seuil négative d'un transistor programmé et la tension de seuil positive d'un transistor effacé (mémoires EEPROM).

En pratique, il arrive que des imperfections de fabrication affectent la stabilité de certaines cellules entraînant occasionnellement une erreur de lecture d'un bit. Par exemple, la tension de seuil négative d'un transistor programmé, qui représente par convention un bit à "1", peut lentement évoluer vers une valeur positive. Tant que la tension de seuil reste inférieure à la tension de référence Vt₀, le transistor est considéré comme programmé. Toutefois, la tension de seuil peut également évoluer sensiblement au-delà de la tension de référence Vt₀. Il se produit alors une corruption de donnée, un "0" étant lu dans la mémoire au lieu du "1" initialement enregistré, ou inversement.

Pour cette raison, une mémoire non volatile est généralement pourvue d'un circuit de correction d'erreur, pour détecter et corriger un bit erroné dans une chaîne de bits au moyen d'un code de correction d'erreur (ECC). Le code de correction d'erreur est inséré dans la chaîne de bits au moment de son enregistrement dans la mémoire, et est calculé au moyen d'un algorithme déterminé, par exemple l'algorithme de Haming bien connu de l'homme de l'art.

L'inconvénient de l'algorithme de Hamming, et plus généralement de tout algorithme de détection et de correction d'erreur, est qu'il génère des codes d'une longueur non négligeable au regard du nombre de bits à sécuriser. La prévision d'un tel code de correction complique l'architecture de la mémoire en raison du nombre de cellules mémoire supplémentaires devant être prévues pour son enregistrement. De plus, le circuit de correction d'erreur est d'autant plus complexe que le code de correction est long.

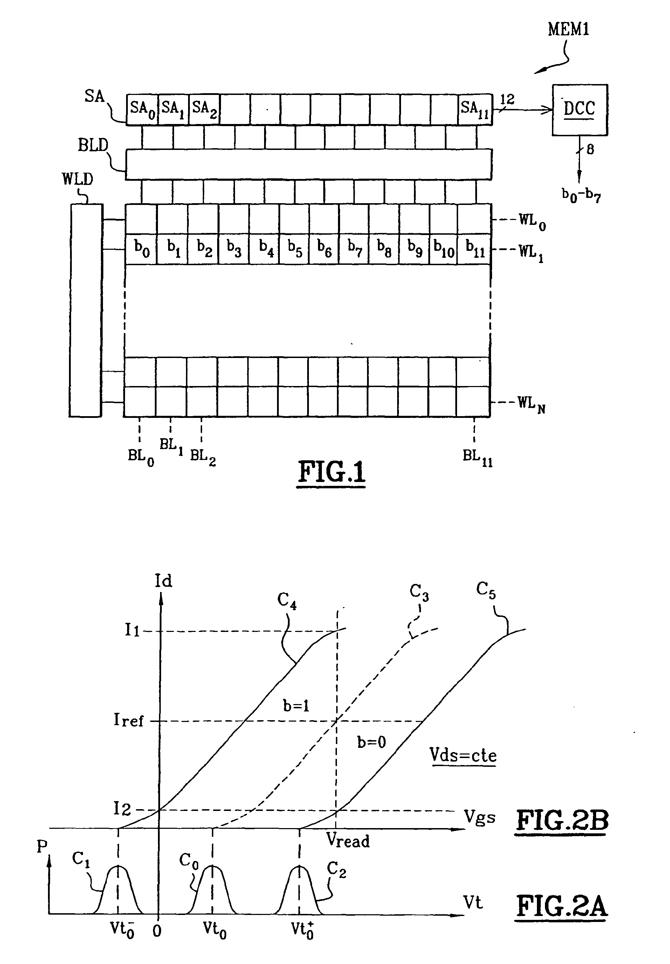

Pour fixer les idées, la figure 1 représente schématiquement l'architecture d'une mémoire MEM1 comprenant des lignes de mots WL₀ à WL_{N} et des lignes de bits BL₀ à BL₁₁. La mémoire MEM1 est pourvue d'un décodeur de lignes de mots WLD, d'un décodeur de lignes de bits BLD et d'un circuit de lecture SA comprenant 12 circuits de lecture élémentaires SA₀ à SA₁₁ ("sensé amplifiers"). Chaque ligne de mot WLᵢ comprend 8 bits de données b₀ à b₇ et quatre bits de contrôle b₈ à b₁₁ formant par exemple un code de Hamming, permettant de détecter et de corriger un bit erroné parmi les 12 bits b₀ à b₁₁. Lorsqu'une ligne de mot est sélectionnée par le décodeur WLD et que les cellules correspondantes sont activées en lecture par le décodeur BLD, le circuit SA délivre les 12 bits b₀ à b₁₁ de la ligne de mot sélectionnée. Les bits b₀ à b₁₁ sont envoyés à un circuit de correction DCC, qui délivre en sortie les huit bits de données b₀ à b₇ après avoir éventuellement détecté et corrigé un bit erroné.

Une telle mémoire présente l'inconvénient de comprendre 33% de cellules réservées à la détection et à la correction des défaillances éventuelles des autres cellules mémoire.

Un objectif de la présente invention est de prévoir un moyen permettant de réduire la taille des codes de correction d'erreur dans les mémoires non volatiles, et de simplifier l'architecture des mémoires et la structure des circuits de correction d'erreur.

On connaît déjà, par la demande EP 307 958, une mémoire EEPROM comprenant des amplificateurs de lecture [30] délivrant des bits de données [d0 à d4] et des amplificateurs de lecture [31] délivrant des signaux d'erreurs [e0 à e4] lorsque la tension de seuil d'une cellule mémoire se trouve dans une bande interdite. Cette mémoire comprend un circuit de correction d'erreur [52] représenté en figure 9 du document, agencé pour corriger un bit erroné en inversant la valeur du bit erroné lorsque le signal d'erreur correspondant indique une erreur de lecture. Cette inversion de la valeur d'un bit erroné est effectuée au moyen d'une porte Ou Exclusif [58] qui reçoit le bit erroné sur une première entrée et la sortie d'une porte ET sur une seconde entrée. La porte ET reçoit en entrée le signal d'erreur [e0 à e4] et un bit de parité calculé par un circuit [66] à partir d'une chaîne de bits comprenant le bit erroné et un bit de parité enregistré dans la mémoire. Lorsque le bit de parité calculé par le circuit [66] est à 1 (ce qui signifie qu'il y a une erreur de lecture puisque le bit de parité d'une chaîne de bits incorporant un bit de parité est toujours égal à 0) et que, simultanément, le signal d'erreur du bit de donnée est à 1, la sortie de la porte ET passe à 1. La porte Ou Exclusif [58] fonctionne alors comme une porte inverseuse à l'égard du bit erroné reçu sur son autre entrée, et délivre un "0" si le bit erroné est à "1" ou un "1" si le bit erroné est à "0".

Ce procédé de correction peut être considéré comme complexe à mettre en oeuvre en raison de la réalisation de chacune des portes Ou Exclusif [58], qui nécessite l'emploi de nombreuses portes logiques élémentaires.

Un autre objectif de la présente invention est de prévoir un procédé de correction d'erreur qui soit simple à mettre en oeuvre et puisse être mis en oeuvre au moyen de simples commutateurs tels des multiplexeurs, en ne nécessitant qu'un nombre réduit de portes logiques.

Pour atteinte ces objectifs, la présente invention prévoit un procédé de correction d'un bit erroné dans une chaîne de bits, comprenant une étape consistant à prévoir dans la chaîne de bits un premier bit de parité calculé à partir des autres bits de la chaîne de bits à un instant où le bit erroné était valable, une étape consistant à calculer un second bit de parité en fonction de tous les bits de la chaîne de bits autres que le bit erroné, et une étape consistant à remplacer le bit erroné par le second bit de parité.

Selon un mode de réalisation, le bit erroné reçoit par convention une valeur logique sans influence sur le calcul de parité, et le second bit de parité est calculé à partir de tous les bits de la chaîne de bits, y compris le bit erroné.

Selon un mode de réalisation, le bit erroné est remplacé par le second bit de parité au moyen d'un circuit multiplexeur.

Selon un mode de réalisation, la chaîne de bits est lue dans une mémoire non volatile.

Selon un mode de réalisation, pour corriger plus qu'un bit dans un mot binaire, on décompose la chaîne de bits en au moins deux chaînes de bits comprenant chacune un bit de parité.

La présente invention concerne également une mémoire non volatile comprenant des cellules mémoire rémanentes, des moyens de lecture d'une chaîne de bits dans la mémoire et des moyens de correction d'un bit erroné présent dans une chaîne de bits lue dans la mémoire, les moyens de correction comprenant des moyens pour calculer un bit de parité à partir des bits de la chaîne de bits, et des moyens pour remplacer un bit erroné par le bit de parité calculé.

Selon un mode de réalisation, les moyens de lecture sont agencés pour attribuer à un bit erroné une valeur logique sans influence sur un calcul de parité, et les moyens pour calculer un bit de parité sont agencés pour recevoir en entrée tous les bits de la chaîne de bits, y compris un bit erroné.

Selon un mode de réalisation, les moyens pour remplacer un bit erroné par le bit de parité calculé comprennent un circuit multiplexeur.

Selon un mode de réalisation, les moyens de lecture sont agencés pour délivrer un bit ayant une première valeur logique quand une caractéristique rémanente d'une cellule mémoire est supérieure à un premier seuil, délivrer un bit ayant une deuxième valeur logique quand la caractéristique rémanente d'une cellule mémoire est inférieure à un second seuil inférieur au premier seuil, et délivrer un signal de bit erroné quand la caractéristique rémanente d'une cellule mémoire est comprise entre le premier et le second seuils.

Selon un mode de réalisation, les moyens de lecture sont agencés pour délivrer un bit ayant la deuxième valeur logique quand la caractéristique rémanente d'une cellule mémoire est inférieure au premier seuil.

Selon un mode de réalisation, les moyens de lecture sont agencés pour comparer le courant traversant une cellule à deux courants de référence, et émettre le signal de bit erroné lorsque le courant traversant le transistor à grille flottante est compris entre les deux courants de référence.

Selon un mode de réalisation, les moyens de lecture comprennent un premier comparateur pour comparer le courant traversant une cellule à un premier courant de référence, délivrant un premier bit utilisé en tant que bit de donnée lu dans la cellule, un second comparateur pour comparer le courant traversant une cellule à un second courant de référence, délivrant un second bit, et une fonction OU Exclusif pour combiner le premier bit et le second bit et délivrer un signal de bit erroné.

Selon un mode de réalisation, le premier et le second seuils définissent une région comprenant le domaine des cellules vierges ou comprise dans le domaine des cellules vierges, de sorte que l'état erroné d'un bit reste stable dans le temps.

Ces caractéristiques de la présente invention, ainsi que d'autres, seront exposées plus en détail dans la description suivante d'un procédé de lecture d'une cellule mémoire incorporant une fonction de détection d'erreur, et d'un procédé de correction d'erreur selon l'invention, en relation avec les figures jointes parmi lesquelles :
- la figure 1 représente schématiquement l'architecture d'une mémoire non volatile classique,
- les figures 2A, 2B illustrent un procédé classique de lecture d'une cellule mémoire,
- la figure 3 est le schéma électrique classique d'un circuit de lecture d'une cellule mémoire,
- les figures 4A, 4B illustrent un procédé de lecture d'une cellule mémoire avec détection d'erreur,
- la figure 5 est le schéma électrique d'un circuit de lecture selon l'invention, permettant de lire une cellule mémoire avec détection d'erreur,
- la figure 6 illustre un procédé selon l'invention permettant de corriger un bit erroné,
- la figure 7 représente de façon schématique l'architecture d'une mémoire non volatile selon l'invention, et
- la figure 8 représente le schéma électrique d'un circuit de correction d'erreur selon l'invention, présent dans la mémoire de la figure 7.

La figure 2A représente trois courbes C0, C1, C2 illustrant la distribution statistique des tensions de seuil Vt d'un transistor à grille flottante selon l'état du transistor, l'axe des ordonnées représentant une probabilité P. La courbe C0, centrée sur une valeur positive Vt₀, représente la distribution de la tension de seuil Vt d'un transistor vierge qui n'a jamais été programmé ou effacé ou qui a été effacé au moyen d'une lumière ultraviolette. La courbe C1, centrée sur une valeur négative Vt₀⁻, représente la distribution de la tension de seuil négative Vt-d'un transistor programmé, et correspond par convention à un bit égal à 1. La courbe C2, centrée sur une valeur positive Vt₀⁺ supérieure à Vt₀, représente la distribution de la tension de seuil positive Vt⁺ d'un transistor effacé, et correspond par convention à un bit égal à 0.

La figure 2B représente, en liaison avec la figure 2A, des courbes C3, C4, C5 du courant Id traversant un transistor à grille flottante en fonction de la tension grille-source Vgs qui lui est appliquée, pour une tension drain-source Vds constante. La courbe C3 est la courbe courant/tension d'un transistor vierge de tension de seuil Vt₀. La courbe C4 est la courbe courant/tension d'un transistor programmé ayant une tension de seuil Vt₀-et la courbe C5 est la courbe courant/tension d'un transistor effacé ayant une tension de seuil Vt₀⁺.

La détection de la tension de seuil Vt d'un transistor, permettant la lecture d'un bit, est réalisée par une mesure du courant Id traversant le transistor en appliquant sur sa grille une tension de lecture V_{read} prédéterminée. Le point de fonctionnement correspondant sur la courbe C3 (cellule vierge) donne un courant I_{ref}. Ainsi, un transistor dans l'état programmé ayant une tension de seuil Vt comprise dans la courbe C1 de la figure 2A présente un courant Id supérieur à I_{ref}, et un transistor dans l'état effacé ayant une tension de seuil Vt comprise dans la courbe C2 présente un courant Id inférieur à I_{ref}. Par exemple, des transistors ayant respectivement des tensions de seuil égales aux tensions Vt₀⁻ et Vt₀⁺ (courbes C4 et C5) sont traversés par des courants I1 et I2 représentés sur la figure 2B lorsque la tension V_{read} leur est appliquée.

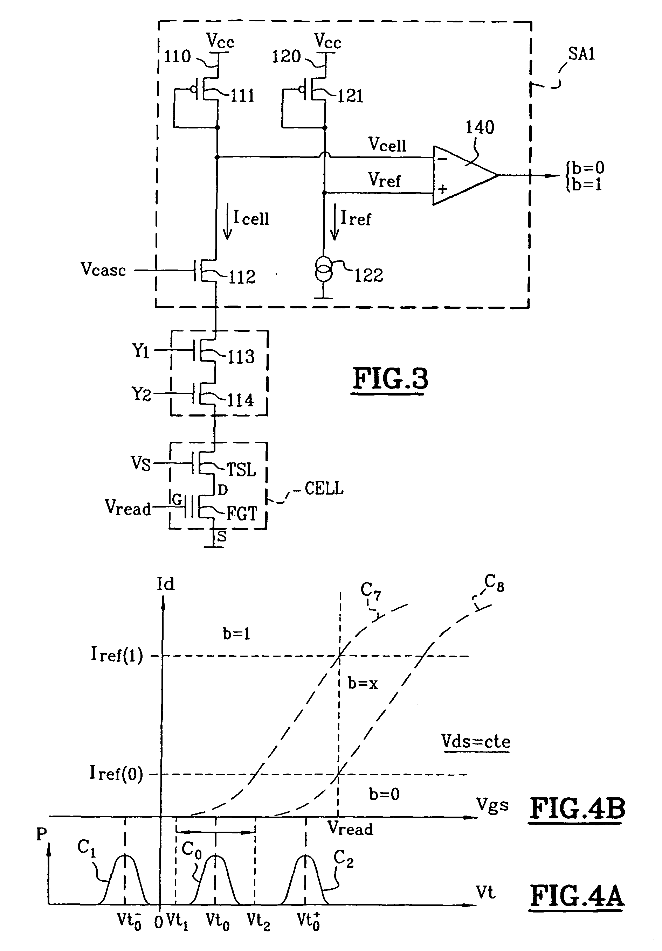

La figure 3 représente un circuit de lecture SA1 généralement appelé amplificateur de lecture ("sense amplifier"), prévu pour lire une cellule mémoire CELL sans détection d'erreur. La cellule mémoire CELL est agencée dans une ligne de bit 110 alimentée par une tension Vcc, comprenant en série un transistor-diode 110, un transistor cascode 112, deux transistors 113, 114 de sélection de la ligne de bit et la cellule mémoire CELL. La cellule mémoire CELL comprend en série un transistor de sélection de cellule TSL et un transistor à grille flottante FGT. Le circuit de lecture SA1 comprend le transistor-diode 111 et le transistor cascode 112 susmentionnés, une branche 120 et un comparateur 140. La branche 120 comprend en série un transistor-diode 121 et un générateur de courant 122 délivrant le courant de référence I_{ref} précédemment décrit. La cathode du transistor-diode 111 est connectée à l'entrée négative du comparateur 140 et la cathode du transistor-diode 121 est connectée à l'entrée positive du comparateur 140.

Pour sélectionner la ligne de bit et lire la cellule CELL, deux signaux Y1, Y2 délivrés par un décodeur de lignes de bits sont appliqués sur les grilles des transistors 113, 114. Une tension Vcasc est appliquée sur le transistor 112, une tension Vs est appliquée sur la grille du transistor de sélection TSL et la tension de lecture V_{read} est appliquée sur la grille du transistor FGT. Le courant drain-source I_{cell} traversant le transistor FGT fait apparaître une tension V_{cell} sur la cathode du transistor-diode 111. Le comparateur 140 reçoit ainsi sur son entrée négative la tension V_{cell} et sur son entrée positive une tension V_{ref} délivrée par la branche 120, et sa sortie délivre le bit "b" enregistré dans la cellule. Le bit "b" est à 1 si le courant I_{cell} est supérieur à I_{ref} ou à 0 si le courant I_{cell} est inférieur à ^{I}ref.

Comme cela a été expliqué au préambule, l'existence d'un défaut de fabrication du transistor FGT peut avoir comme conséquence le fait que la tension de seuil Vt⁻ du transistor FGT dans l'état programmé, appartenant à la courbe C1 (figure 2A), évolue lentement vers des valeurs positives se trouvant dans région comprenant la courbe C0, qui représente le domaine des cellules vierges. Tant que la tension Vt⁻ reste inférieure à la tension Vt₀ le circuit de lecture SA1 délivre un bit à 1. Toutefois, la tension Vt⁻ peut également évoluer sensiblement au-delà de la tension Vt₀, tout en restant dans le domaine des cellules vierges car un transistor programmé ne peut pas naturellement devenir un transistor effacé, et inversement. Le dépassement de la tension Vt₀ provoque une corruption de donnée car la sortie du circuit de lecture SA1 délivre dans ce cas un bit à 0. Inversement, la tension de seuil Vt⁺ du transistor FGT dans l'état effacé, appartenant à la courbe C2, peut évoluer vers des valeurs faibles se trouvant dans la partie gauche du domaine des cellules vierges. Le circuit de lecture SA1 délivre alors un bit à 1 au lieu d'un bit à 0, ou inversement.

Pour lire une cellule mémoire tout en détectant la présence d'un bit erroné, on définit sur la figure 4A, qui est identique à la figure 2A, une région "interdite" délimitée par deux tensions Vt₁ et Vt₂, la tension Vt₂ étant supérieure à Vt₁. La tension Vt₁ est de préférence comprise entre la courbe C1 et la courbe C0 et la tension Vt₂ comprise entre la courbe C0 et la courbe C2. En d'autres termes, la région interdite comprend le domaine des cellules vierges où se produisent les phénomènes de corruption de données, comme on l'a vu plus haut. Toute cellule mémoire présentant une tension de seuil Vt comprise dans la région interdite sera réputée contenir un bit erroné. L'état "erroné" selon l'invention reste stable dans le temps car la tension de seuil d'un transistor initialement programmé ou effacé, ayant évolué vers le domaine des cellules vierges, ne peut pas évoluer naturellement au-delà de ce domaine. Sur la figure 4B, qui est semblable à la figure 2B, les deux tensions Vt₁, Vt₂ correspondent à deux courbes tension/courant C7, C8, pour une tension de polarisation drain-souce Vds constante et déterminée. En choisissant une tension de lecture V_{read} supérieure à la tension Vt₂, appliquée sur la grille d'une cellule mémoire, les points de fonctionnement correspondants sur les courbes C7, C8 définissent deux courants I_{ref (1)}, I_{ref (0)}qui sont respectivement supérieur et inférieur au courant de référence I_{ref} utilisé dans l'art antérieur pour lire une cellule. Ainsi, tout transistor à grille flottante ayant un courant drain-source Id supérieur à I_{ref (1)} sera réputé contenir un bit à 1, tout transistor à grille flottante ayant un courant drain-source Id inférieur à I_{ref (0)} sera réputé contenir un bit à 0, et tout transistor à grille flottante ayant un courant de fonctionnement Id compris entre I_{ref (0)}et I_{ref (1)} sera réputé contenir un bit erroné.

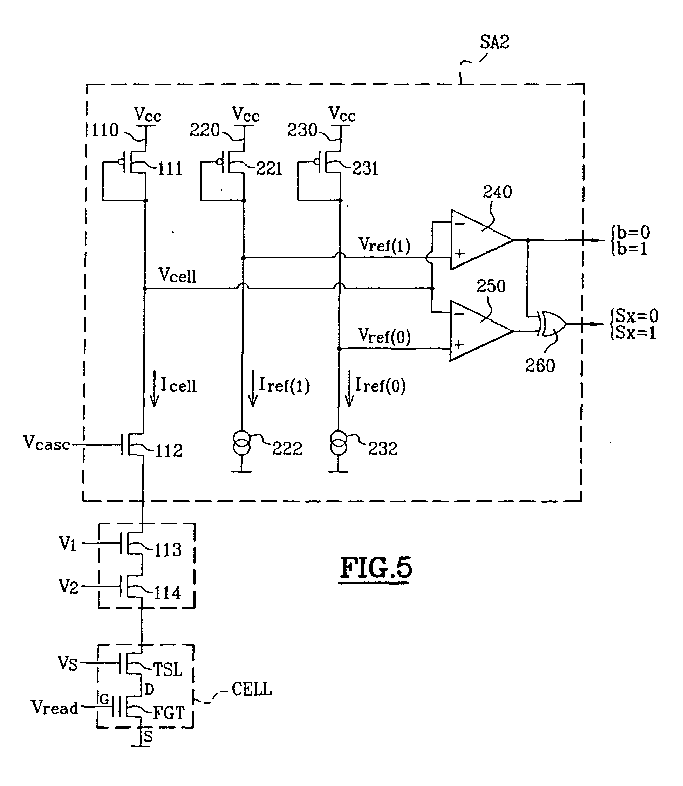

La figure 5 représente un circuit de lecture SA2 avec détection d'erreur, connecté à une cellule mémoire CELL agencée dans une ligne de bit 110. La cellule CELL et la ligne de bit 110 ont été décrites plus haut en relation avec la figure 3. Le circuit de lecture SA2 comprend le transistor-diode 110 et le transistor cascode 112 de la ligne de bit 110, deux branches 220, 230 et deux comparateurs 240, 250. La branche 220 comprend un transistor-diode 221 et un générateur de courant 222 délivrant le courant de référence I_{ref (1)} décrit plus haut. La branche 230 comprend un transistor-diode 231 et un générateur de courant 232 délivrant le courant de référence I_{ref (0)}décrit plus haut. La ligne de bit 110 délivre une tension V_{cell}prélevée sur la cathode du transistor-diode 111, la branche 220 délivre une tension V_{ref (1)} prélevée sur la cathode du transistor-diode 221 et la branche 230 délivre une tension V_{ref (0)} prélevée sur la cathode du transistor-diode 231. Les tensions V_{cell}, V_{ref (1)} sont appliquées respectivement sur l'entrée négative et l'entrée positive du comparateur 240 dont la sortie délivre le bit "b" lu dans la cellule. Les tensions V_{cell}, V_{ref (0)} sont appliquées respectivement sur l'entrée négative et l'entrée positive du comparateur 250 dont la sortie est combinée avec la sortie du comparateur 240 dans une porte OU Exclusif 260. La sortie de la porte 260 délivre un signal d'erreur Sx.

Le fonctionnement du circuit SA2 est décrit par le tableau ci-après. Par convention, le signal Sx égal à 1 indique une erreur de lecture.

| Etat de la cellule | Courant I_{cell} | Bit "b" | Signal Sx |
|---|---|---|---|
| Programmée | I _{cell} > I_{ref (1)} | b = 1 | 0 |
| Effacée | I_{cell} < I_{ref (0)} | b = 0 | 0 |
| Etat Indéterminé (cellule vierge) | I_{ref (0)}< I_{cell} < I_{ref (1)} | b = 0 | 1 (erreur) |

Le circuit SA2 permet ainsi de détecter une cellule "douteuse" dont la tension de seuil Vt s'est décalée depuis sa valeur originelle pour entrer dans la région interdite définie plus haut, qui comprend le domaine des cellules vierges. Ici, un bit b erroné correspond à un "0" à la sortie du comparateur 240 mais cette valeur est sans importance puisque le signal Sx égal à "1" indique que le bit doit être corrigé. Comme on l'a indiqué plus haut, un bit erroné reste stable dans le temps et ne peut pas tendre vers la valeur 0 ou 1 car le domaine des cellules vierges est stable par nature.

Le procédé de lecture qui vient d'être décrit permet de détecter un bit erroné. Un bit erroné étant généralement inclus dans une chaîne de bits, il peut être corrigé au moyen de tout algorithme classique, en insérant un code de correction dans la chaîne de bits. Toutefois, on rappelle ici que l'objectif de la présente invention est de prévoir un procédé de correction qui soit simple à mettre en oeuvre et nécessite un code de correction de faible longueur. La détection d'erreur étant effectuée au stade de la lecture du bit, il suffit que le procédé permette de corriger le bit erroné et il n'est pas nécessaire qu'il le détecte.

Selon l'invention, la correction d'un bit erroné nécessite tout d'abord de prévoir, de façon en soi classique, une chaîne de bit comprenant un premier bit de parité stocké en mémoire, calculé à un moment où les bits de la chaîne de bits sont présumés valables. Lorsqu'un bit erroné est détecté, on calcule un second bit de parité à partir de tous les bits de la chaîne de bits y compris le premier bit de parité (le bit de parité initial) à l'exclusion du bit erroné. Le second bit de parité ainsi calculé donne la bonne valeur du bit erroné, et le bit erroné est remplacé par le second bit de parité. Rappelons ici qu'un bit de parité est par convention égal à 1 quand le nombre de bits à 1 est impair, et à 0 quand le nombre de bits à 1 est pair.

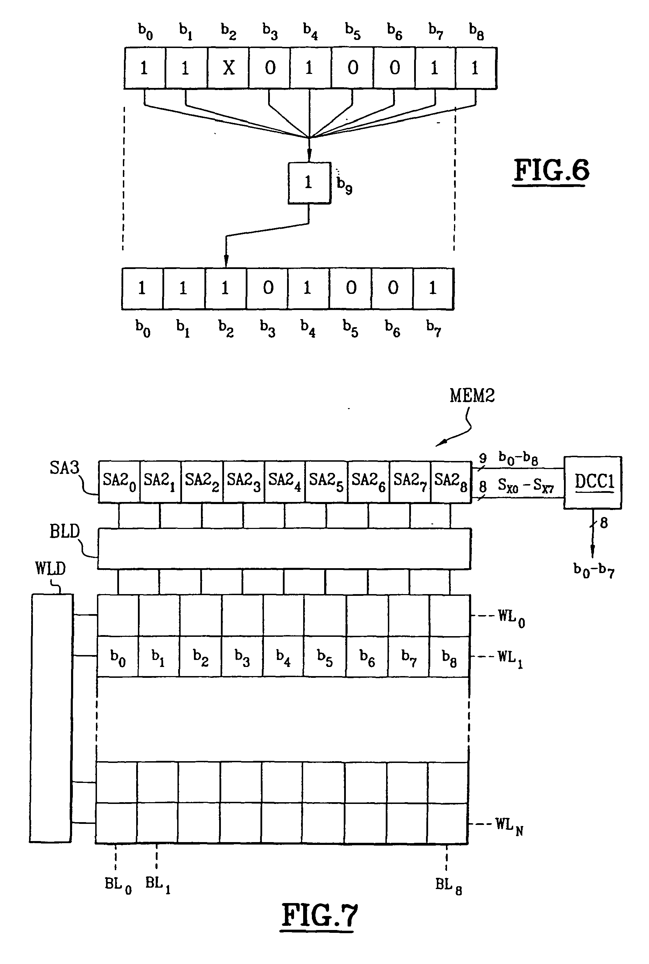

Le procédé selon l'invention est illustré par la figure 6, qui représente la chaîne de bits b₀ à b₈ suivante :
1 1 X 0 1 0 0 1 1 dans laquelle le bit b₈ est le bit de parité des bits b₀ à b₇, calculé à un instant où ceux-ci sont présumés valables. Le bit b₂ est présumé erroné et sa valeur est représentée par un "X". Selon l'invention, on calcule un nouveau bit de parité b₉ à partir des bits b₀, b₁, b₃ à b₈. Le nouveau bit de parité b₉, ici égal à 1, est placé dans la chaîne de bits à la place du bit erroné b₂.

Outre son extrême simplicité, ce procédé présente l'avantage de ne nécessiter qu'un seul bit de parité pour corriger un bit erroné, quelle que soit la longueur de la chaîne de bits. Il est bien entendu possible de prévoir deux bits de parité dans une chaîne de bits pour corriger deux bits erronés, trois bits de parité pour corriger trois bits erronés, etc.. Par exemple, la chaîne suivante:
b₀ b₁ b₂ b₃ b₄ b₅ b₆ b₇ b₈ b₉ comporte 8 bits de données b₀ à b₇. Le bit b₈ est le bit de parité des bits b₀-b₃ et le bit b₉ est le bit de parité des bits b₄-b₇.

Bien entendu, le calcul de parité peut être effectué selon toute autre convention, par exemple en prenant en compte le nombre impair de bits à 0 ou le nombre pair de bits à 1. De plus, le bit de parité n'est pas nécessairement placé en bout de chaîne et peut occuper un rang prédéterminé dans une chaîne de bits.

Enfin, comme on le verra plus loin, le second bit de parité permettant de corriger un bit erroné peut être calculé à partir de tous les bits d'une chaîne de bit y compris le bit erroné, en attribuant par convention à un bit erroné une valeur sans influence sur un calcul de parité (par exemple "0" pour un calcul de parité fondé sur le nombre de bits à "1").

On décrira maintenant un exemple de mise en oeuvre du procédé selon l'invention dans une mémoire MEM2 représentée schématiquement sur la figure 7.

La mémoire MEM2 comprend des lignes de mots WL₀ à WL_{N} et des lignes de bits BL₀ à BL₈ comprenant chacune 8 bits de données b₀ à b₇ et un bit de parité b₈. La mémoire MEM1 comprend également un décodeur de lignes de mots WLD, un décodeur de lignes de bits BLD et un circuit de lecture SA3. Le circuit SA3 comprend 8 circuits de lecture SA2₀ à SA2₇ et un circuit de lecture SA1₈. Les circuits SA2₀ à SA2₇ sont conformes au circuit SA2 décrit plus haut en relation avec la figure 5, et sont dédiés à la lecture des bits de données b₀-b₇. Le circuit SA1₈ est conforme au circuit classique SA1 décrit en relation avec la figure 3 et est dédié à la lecture du bit de parité b₈. Le circuit de lecture du bit de parité pourrait bien entendu être un circuit SA2, mais la détection d'une erreur sur le bit de parité ne présente pas ici un grand intérêt. Ainsi, le circuit SA3 délivre en sortie les neuf bits b₀-b₈ d'une ligne de mot WLᵢ sélectionnée par le décodeur WLD et huit signaux d'erreur Sx₀ à SX₇ correspondant aux bits de données b₀ à b₇. Les bits b₀ à b₈ et les signaux Sx₀ à Sx₇ sont appliqués à l'entrée d'un circuit de correction d'erreur DCC1 selon l'invention. Le circuit DCC1 délivre en sortie les huit bits de données b₀ à b₇ après avoir, si nécessaire, corrigé un bit erroné bᵢ, si le signal Sxᵢ émis pour ce bit est égal à 1.

Il est clair que la mémoire MEM2 est d'une structure plus simple que la mémoire MEM1 décrite au préambule, puisqu'un seul bit de correction b₈ est associé à chaque mot de 8 bits. Ainsi, les bits de correction ne représentent ici que 12,5 % des cellules mémoire contre 33% dans la mémoire MEM1 de la figure 1. De plus, le circuit de correction peut être réalisé de façon simple comme cela sera décrit maintenant.

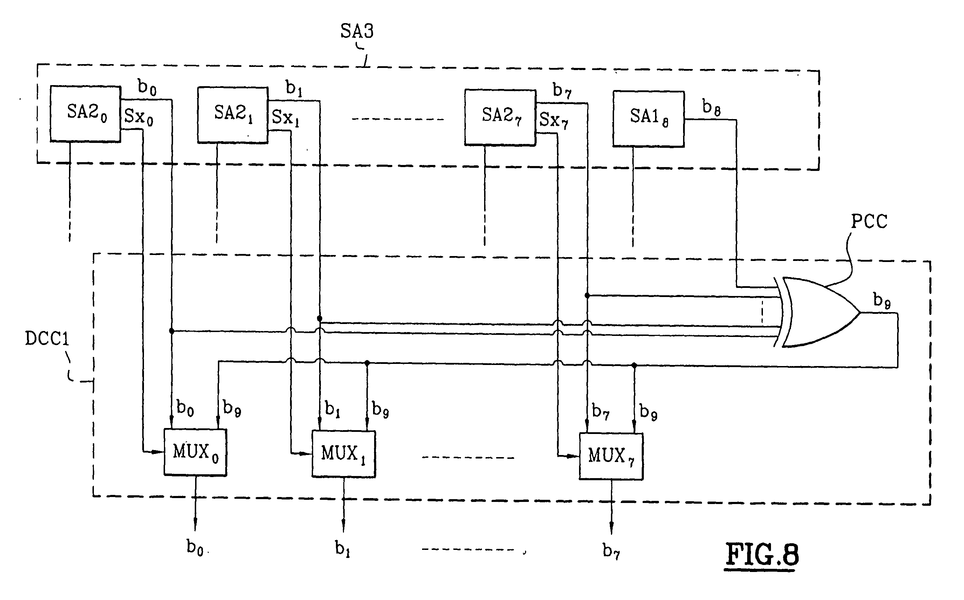

La figure 8 représente un mode de réalisation du circuit de correction DCC1 au moyen de huit multiplexeurs MUXO à MUX7 et d'un circuit PCC de calcul de parité, prenant ici la forme d'une porte OU Exclusif à neuf entrées. Le circuit PCC reçoit en entrée les neuf bits b₀ à b₈ délivrés par le circuit de lecture SA3 et délivre un bit de parité b₉. Les multiplexeurs MUXO à MUX7 comprennent chacun deux entrées de données et une entrée de commande. Chaque multiplexeur MUXO à MUX7 reçoit sur sa première entrée de donnée l'un des bits b₀ à b₇ délivrés par les circuits SA2₀-SA2₇, reçoit le bit de parité b₉ sur son autre entrée de donnée et l'un des signaux Sx₀-Sx₇ sur son entrée de commande.

Le fonctionnement du circuit correcteur DCC1 est particulièrement simple. Chaque multiplexeur MUX0 à MUX7 sélectionne sur sa sortie le bit bᵢ reçu en entrée si le signal Sxᵢ sur l'entrée de commande est à 0, ou sélectionne sur sa sortie le bit de parité b₉ si le signal Sxᵢ est égal à 1 (bit erroné). Le circuit DCC1 réalise ainsi le procédé décrit plus haut, en remplaçant un bit erroné par le bit de parité b₉ calculé à partir de tous les bits du mot binaire b₀-b₈, y compris le bit de parité b₈. Un bit erroné étant ici par convention égal à 0, comme décrit plus haut, son injection sur l'entrée du circuit PCC est sans influence sur le calcul de parité, qui ne prend en compte que le nombre de "1" présent dans la chaîne de bits.

Bien entendu, le circuit DCC1 ne peut assurer que la correction d'un seul bit à la fois. Pour corriger deux bits ou plus, il faut ajouter un ou plusieurs bits de parité supplémentaires et décomposer le mot binaire en deux ou plusieurs chaînes de bits élémentaires comprenant chacune un bit de parité, comme cela a déjà été expliqué plus haut.

Dans ce qui précède, on a décrit le procédé de lecture d'un bit en se référant aux cellules mémoires de type EEPROM, dans lesquelles l'état programmé et l'état effacé se traduisent par des tensions de seuil Vt négatives ou positives. Il apparaîtra clairement à l'homme de l'art que l'enseignement qui précède est applicable à divers types de cellules mémoire, notamment aux cellules mémoires de type FLASH qui ont des transistors à grille flottante dont la tension de seuil Vt, bien que toujours positive, présente des valeurs différentes entre l'état effacé et l'état programmé, se trouvant respectivement au-dessus et audessous du domaine des cellules vierges. Comme cela est bien connu de l'homme de l'art, le domaine des tensions de seuil des cellules vierges est une caractéristique technologique que l'on maîtrise par un contrôle du dopage des transistors et/ou de l'épaisseur de l'oxyde de grille. Comme précédemment, on définira une région "interdite" délimitée par deux tensions de référence Vt₁, Vt₂ et se trouvant à mi-chemin entre la région des tensions de seuil des transistors programmés et la région des tensions de seuil des transistors effacés. De préférence, cette région interdite doit comprendre le domaine des cellules vierges ou au moins être comprise dans le domaine des cellules vierges, afin que l'état "erroné" selon l'invention soit stable. Par ailleurs, il apparaîtra clairement à l'homme de l'art que le procédé de correction d'erreur selon l'invention peut être combiné avec tout procédé quelconque de détection d'erreur.

## Revendications

1. Procédé de lecture et de correction d'une chaîne de bits (b₀-b₈), chaque bit de la chaîne de bits étant enregistré dans une cellule mémoire (CELL) d'une mémoire non volatile (MEM2), la chaîne de bits incluant un premier bit de parité (b₈) fonction des autres bits (b₀-b₇) de la chaîne de bits, procédé comprenant :
- une étape de lecture de chaque bit de la chaîne de bits comprenant, pour chaque bit à lire, les étapes suivantes :
- détecter une caractéristique électrique rémanente (Vt, Id) de la cellule représentative de la valeur du bit,
- attribuer au bit une première valeur ("1") quand la caractéristique rémanente est supérieure à un premier seuil (I_{ref(1)}) et une deuxième valeur ("0") quand la caractéristique rémanente est inférieure à un second seuil (I_{ref(0)}) inférieur au premier seuil,
- délivrer un signal d'erreur (Sx) de lecture du bit quand la caractéristique rémanente est comprise entre le premier et le second seuils, et
- une étape de correction d'un bit erroné (b₂) quand le signal d'erreur (Sx) est délivré,
**caractérisé en ce que** l'étape de correction du bit erroné comprend :
- une étape consistant à calculer un second bit de parité (b₉) en fonction de tous les bits de la chaîne de bits (b₀, b₁, b₃-b₈) autres que le bit erroné (b₂), et
- une étape consistant à remplacer le bit erroné (b₂) par le second bit de parité (b₉).

2. Procédé selon la revendication 1, dans lequel le bit erroné (b₂) reçoit par convention une valeur logique ("0") sans influence sur le calcul de parité, et le second bit de parité (b₉) est calculé à partir de tous les bits (b₀-b₈) de la chaîne de bits, y compris le bit erroné.

3. Procédé selon l'une des revendications 1 et 2, dans lequel le bit erroné est remplacé par le second bit de parité au moyen d'un circuit multiplexeur (MUX₀- MUX₇).

4. Procédé selon l'une des revendications 1 à 3 dans lequel, pour corriger plus qu'un bit dans un mot binaire, on décompose la chaîne de bits en au moins deux chaînes de bits comprenant chacune un bit de parité.

5. Procédé selon l'une des revendications 1 à 4, dans lequel chaque cellule mémoire (CELL) comprend un transistor à grille flottante (FGT), et est lue en appliquant une tension de lecture (V_{read}) sur la grille du transistor et en comparant le courant (Id) traversant le transistor à grille flottante à deux courants de référence (I_{ref(0)}, I_{ief(1)}), le signal d'erreur étant émis lorsque le courant traversant le transistor à grille flottante est compris entre les deux courants de référence.

6. Mémoire non volatile (MEM2) comprenant des cellules mémoire rémanentes (CELL), des moyens (SA2, SA3) de lecture d'une chaîne de bits (b₀-b₈) dans la mémoire et des moyens de correction (DCC1) d'un bit erroné (b₂) présent dans une chaîne de bits (b₀-b₈) lue dans la mémoire, la chaîne de bits incluant un premier bit de parité (b₈) fonction des autres bits (b₀-b₇) de la chaîne de bits,
les moyens de lecture (SA2) étant agencés pour :
- délivrer un bit ayant une première valeur logique ("1") quand une caractéristique rémanente d'une cellule mémoire est supérieure à un premier seuil (I_{ref(1)}),
- délivrer un bit ayant une deuxième valeur logique ("0") quand la caractéristique rémanente d'une cellule mémoire est inférieure à un second seuil (I_{ref(0)}) inférieur au premier seuil (I_{ref(1)}), et
- délivrer un signal de bit erroné (Sx=1) quand la caractéristique rémanente d'une cellule mémoire est comprise entre le premier (I_{ref(0)}) et le second (I_{ref(0)}) seuils,
**caractérisée en ce que** les moyens de correction comprennent :
- des moyens (PCC) pour calculer un second bit de parité (b₉) en fonction de tous les bits de la chaîne de bits (b₀, b₁, b₃-b₈) autres que le bit erroné (b₂), et
- des moyens (MUX₀- MUX₇) pour remplacer un bit erroné (b₂) par le bit de parité (b₉) calculé.

7. Mémoire selon la revendication 6, dans laquelle les moyens de lecture (SA2, SA3) sont agencés pour attribuer à un bit erroné (b₂) une valeur logique ("0") sans influence sur un calcul de parité, et les moyens (PCC) pour calculer un second bit de parité (b₉) sont agencés pour recevoir en entrée tous les bits (b₀-b₈) de la chaîne de bits, y compris un bit erroné.

8. Mémoire selon l'une des revendications 6 et 7, dans lequel les moyens pour remplacer un bit erroné par le bit de parité calculé comprennent un circuit multiplexeur (MUX₀- MUX₇).

9. Mémoire selon l'une des revendications 6 à 8, dans laquelle les moyens de lecture (SA2) sont agencés pour délivrer un bit ayant la deuxième valeur logique ("0") quand la caractéristique rémanente d'une cellule mémoire est inférieure au premier seuil.

10. Mémoire selon la revendication 9, dans laquelle les moyens de lecture (SA2) sont agencés pour comparer le courant traversant une cellule à deux courants de référence (I_{ref(1)}, I_{ref(0)}), et émettre le signal de bit erroné (Sx=1) lorsque le courant traversant le transistor à grille flottante est compris entre les deux courants de référence.

11. Mémoire selon la revendication 10, dans laquelle les moyens de lecture (SA) comprennent :
- un premier comparateur (240) pour comparer le courant traversant une cellule à un premier courant de référence (I_{ref(1)}), délivrant un premier bit ("b") utilisé en tant que bit de donnée lu dans la cellule,
- un second comparateur (250) pour comparer le courant traversant une cellule à un second courant de référence (I_{ref(0)}), délivrant un second bit, et
- une fonction OU Exclusif (260) pour combiner le premier bit et le second bit et délivrer un signal de bit erroné (Sx).

12. Mémoire selon l'une des revendications 6 à 11, dans laquelle le premier (I_{ref(1)}) et le second (I_{ref(0)}) seuils définissent une région comprenant le domaine des cellules vierges ou comprise dans le domaine des cellules vierges, de sorte que l'état erroné d'un bit reste stable dans le temps.

## Claims

1. Method for reading and correcting a string of bits (b₀-b₈), every bit of the string of bits being stored in a memory cell (CELL) of a non-volatile memory (MEM2), the string of bits including a first parity bit (b₈) as a function of the other bits (b₀-b₇) of the string of bits, the method comprising:
- a step of reading every bit of the string of bits comprising for every bit to be read the following steps:
- detecting a remanent electrical characteristic (Vt, Id) of the cell representing the value of the bit,
- assigning a first value ("1") to the bit if the remanent characteristic is above a first threshold (I_{ref(0)}), and a second value ("0") if the remanent characteristic is lower than a second threshold (I_{ref(0)}) which is lower than the first threshold,
- delivering a read error signal (Sx) of the bit if the remanent characteristic is between the first and second thresholds, and
- a step of correcting an erroneous bit (b₂) when the erroneous signal (Sx) is delivered,
**characterized in that** the step of correcting the erroneous bit comprises:
- a step consisting of calculating a second parity bit (b₉) as a function of all the bits of the string of bits (b₀, b₁, b₃-b₈) other than the erroneous bit (b₂), and
- a step consisting of replacing the erroneous bit (b₂) by the second parity bit (b₉).

2. Method according to claim 1, wherein the erroneous bit (b₂) receives by convention a logic value ("0") that has no effect on the parity computation, and wherein the second parity bit (b₉) is computed from all the bits (b₀-b₈) of the string of bits, including the erroneous bit.

3. Method according to any of claims 1 and 2, wherein the erroneous bit is replaced by the second parity bit by means of a multiplexer circuit (MUX₀-MUX₇).

4. Method according to any of claims 1 to 3, wherein the string of bits is split up into at least two strings of bits, each comprising a parity bit, in order to correct more than one bit in a binary word.

5. Method according to any of claims 1 to 4, wherein every memory cell (CELL) comprises a floating gate transistor (FGT) and is read by applying a read voltage (V_{read}) to the gate of the transistor and by comparing the current (Id) flowing through the floating gate transistor with two reference currents (I_{ref(0)}, I_{ref(1)}), the error signal being emitted when the current flowing through the floating gate transistor is between the two reference currents.

6. Non-volatile memory (MEM2) comprising remanent memory cells (CELL), means (SA2, SA3) for reading a string of bits (b₀-b₈) in the memory, and means for correcting (DCC1) an erroneous bit (b₂) present in a string of bits (b₀-b₈) which is read in the memory, the string of bits including a first parity bit (b₈) as a function of the other bits (b₀-b₇) of the string of bits,
wherein the reading means (SA2) are configured to:
- deliver a bit having a first logic value ("1") if a remanent characteristic of a memory cell is greater than a first threshold (I_{ref(0)}),
- deliver a bit having a second logic value ("0") if the remanent characteristic of a memory cell is lower than a second threshold (I_{ref(0)}) which is lower than the first threshold (I_{ref(1)}), and
- deliver an erroneous bit signal (Sx=1) if the remanent characteristic of a memory cell is between the first (I_{ref(1)}) and second (I_{ref(0)}) thresholds,
**characterized in that** the correction means comprise:
- means (PCC) for computing a second parity bit (b₉) as a function of all the bits of the string of bits (b₀, b₁, b₃-b₈) other than the erroneous bit (b₂), and
- means (MUX₀-MUX₇) for replacing an erroneous bit (b₂) by the computed parity bit (b₉).

7. Memory according to claim 6, wherein the reading means (SA2, SA3) are configured to assign a logic value ("0") to an erroneous bit (b₂) having no effect on a parity computation, and wherein the means (PCC) for computing a second parity bit (b₉) are configured to receive at an input all the bits (b₀-b₈) of the string of bits, including an erroneous bit.

8. Memory according to any of claims 6 and 7, wherein the means for replacing an erroneous bit by the computed parity bit comprise a multiplexer circuit (MUX₀-MUX₇).

9. Memory according to any of claims 6 to 8, wherein the reading means (SA2) are configured to deliver a bit having the second logic value ("0") if the remanent characteristic of a memory cell is lower than the first threshold.

10. Memory according to claim 9, wherein the reading means (SA2) are configured to compare the current flowing through a cell with two reference currents (I_{ref(0)}, I_{ref(0)}), and to send out the erroneous bit signal (Sx=1) if the current flowing through the floating gate transistor is between the two reference currents.

11. Memory according to claim 10, wherein the reading means (SA) comprise:
- a first comparator (240) for comparing the current flowing through a cell with a first reference current (I_{ref(1)}) delivering a first bit ("b") used as the data bit read in the cell,
- a second comparator (250) for comparing the current flowing through a cell with a second reference current (I_{ref(0)}) delivering a second bit, and
- an exclusive OR function (260) for combining the first bit and the second bit and for delivering an erroneous bit signal (Sx).

12. Memory according to any of claims 6 to 11, wherein the first (I_{ref(1)}) and second (I_{ref(0)}) thresholds define a region comprising the domain of the virgin cells or included in the domain of the virgin cells, so that the erroneous state of a bit remains stable in time.

## Patentansprüche

1. Verfahren zum Lesen und Korrigieren einer Kette von Bits (b₀-b₈), wobei jedes Bit der Bitkette in einer Speicherzelle (CELL) eines nichtflüchtigen Speichers (MEM2) gespeichert ist, wobei die Bitkette ein erstes Paritätsbit (b₈) abhängig von den anderen Bits (b₀-b₇) der Bitkette enthält, wobei das Verfahren aufweist:
- einen Schritt des Lesens von jedem Bit der Bitkette, der für jedes zu lesende Bit die folgenden Schritte aufweist:
- Detektieren einer remanenten elektrischen Eigenschaft (Vt, Id) der Zelle, die für den Wert des Bits repräsentativ ist,
- Zuweisen eines ersten Wertes ("1") an das Bit, wenn die remanente Eigenschaft größer als ein erster Schwellenwert (I_{ref(0)}) ist, und eines zweiten Wertes ("0"), wenn die remanente Eigenschaft kleiner als ein zweiter Schwellenwert (I_{ref(0)}) ist, der kleiner als der erste Schwellenwert ist,
- Ausgeben eines Lesefehlersignals (Sx) des Bits, wenn die remanente Eigenschaft zwischen dem ersten und dem zweiten Schwellenwert liegt, und
- einen Schritt des Korrigierens eines fehlerhaften Bits (b₂), wenn das Fehlersignal (Sx) ausgegeben wird,
**dadurch gekennzeichnet, dass** der Schritt des Korrigierens des fehlerhaften Bits aufweist:
- einen Schritt, der aus dem Berechnen eines zweiten Paritätsbits (b₉) abhängig von allen Bits der Bitkette (b₀, b₁, b₃-b₈), die nicht das fehlerhafte Bit (b₂) sind, besteht, und
- einen Schritt, der aus dem Ersetzen des fehlerhaften Bits (b₂) durch das zweite Paritätsbit (b₉) besteht.

2. Verfahren gemäß Anspruch 1, wobei das fehlerhafte Bit (b₂) regelungsbedingt einen logischen Wert ("0") ohne Einfluss auf die Paritätsberechnung erhält, und das zweite Paritätsbit (b₉) ausgehend von allen Bits (b₀-b₈) der Bittkette, einschließlich dem fehlerhaften Bit, berechnet wird.

3. Verfahren gemäß einem der Ansprüche 1 und 2, wobei das fehlerhafte Bit durch das zweite Paritätsbit mittels eines Multiplexer-Schaltkreises (MUX₀-MUX₇) ersetzt wird.

4. Verfahren gemäß einem der Ansprüche 1 bis 3, wobei zum Korrigieren von mehr als einem Bit in einem Binärwort die Bitkette in mindestens zwei Bitketten zerlegt wird, von denen jede ein Paritätsbit aufweist.

5. Verfahren gemäß einem der Ansprüche 1 bis 4, wobei jede Speicherzelle (CELL) einen Schwebendes-Gate-Transistor (FGT, engl. Floating Gate Transistor) aufweist und unter Anlegen einer Lese-Spannung (V_{read}) an das Gate des Transistors und unter Vergleichen des Stroms (Id), der den Schwebendes-Gate-Transistor durchquert, mit zwei Referenzströmen (I_{ref(0)}, I_{ref(1)}) gelesen wird, wobei das Fehlersignal ausgegeben wird, wenn der den Schwebendes-Gate-Transistor durchquerende Strom zwischen den beiden Referenzströmen liegt.

6. Nichtflüchtiger Speicher (MEM2), aufweisend remanente Speicherzellen (CELL), Mittel (SA2, SA3) zum Lesen einer Bitkette (b₀-b₈) in dem Speicher und Mittel zum Korrigieren (DCC1) eines fehlerhaften Bits (b₂), das sich in einer gelesenen Bitkette (b₀-b₈) in dem Speicher befindet, wobei die Bitkette ein erstes Paritätsbit (b₈) abhängig von den anderen Bits (b₀-b₇) der Bitkette enthält,
wobei die Lesemittel (SA2) eingerichtet sind, um:
- ein Bit mit einem ersten logischen Wert ("1") auszugeben, wenn eine remanente Eigenschaft einer Speicherzelle größer als ein erster Schwellenwert (I_{ref(0)}) ist,
- ein Bit mit einem zweiten logischen Wert ("0") auszugeben, wenn die remanente Eigenschaft einer Speicherzelle kleiner als ein zweiter Schwellenwert (I_{ref(0)}) ist, der kleiner als der erste Schwellenwert (I_{ref(1)}) ist, und
- ein fehlerhaftes-Bit-Signal (Sx=1) auszugeben, wenn die remanente Eigenschaft einer Speicherzelle zwischen dem ersten Schwellenwert (I_{ref(0)}) und dem zweiten Schwellenwert (I_{ref(0)}) liegt,
**dadurch gekennzeichnet, dass** die Korrekturmittel aufweisen:
- Mittel (PCC) zum Berechnen eines zweiten Paritätsbits (b₉) in Abhängigkeit von allen Bits der Bitkette (b₀, b₁, b₃-b₈), die nicht das fehlerhafte Bit (b₂) sind, und
- Mittel (MUX₀-MUX₇) zum Ersetzen eines fehlerhaften Bits (b₂) durch das berechnete Paritätsbit (b₉).

7. Speicher gemäß Anspruch 6, wobei die Lesemittel (SA2, SA3) eingerichtet sind, einem fehlerhaften Bit (b₂) einen logischen Wert ("0") ohne Einfluss auf eine Paritätsberechnung zuzuweisen, und wobei die Mittel (PCC) zum Berechnen eines zweiten Paritätsbits (b₉) eingerichtet sind, alle Bits (b₀-b₈) der Bitkette, einschließlich eines fehlerhaften Bits, beim Eingang zu empfangen.

8. Speicher gemäß einem der Ansprüche 6 und 7, wobei die Mittel zum Ersetzen eines fehlerhaften Bits durch das berechnete Paritätsbit einen Multiplexer-Schaltkreis (MUX₀-MUX₇) aufweisen.

9. Speicher gemäß einem der Ansprüche 6 bis 8, wobei die Lesemittel (SA2) eingerichtet sind, ein Bit mit dem zweiten logischen Wert ("0") auszugeben, wenn die remanente Eigenschaft einer Speicherzelle kleiner als der erste Schwellenwert ist.

10. Speicher gemäß Anspruch 9, wobei die Lesemittel (SA2) eingerichtet sind, den Strom, der eine Zelle durchquert, mit zwei Referenzströmen (I_{ref(1)}, I_{ref(0)}) zu vergleichen, und das fehlerhaftes-Bit-Signal (Sx=1) auszusenden, wenn der Strom, der den Schwebendes-Gate-Transistor durchquert, zwischen den beiden Referenzströmen liegt.

11. Speicher gemäß Anspruch 10, wobei die Lesemittel (SA) aufweisen:
- einen ersten Vergleicher (240), um den Strom, der eine Zelle durchquert, mit einem ersten Referenzstrom (I_{ref(1)}) zu vergleichen, der ein erstes Bit ("b") ausgibt, das als in der Zelle gelesenes Datenbit verwendet wird,
- einen zweiten Vergleicher (250), um den Strom, der eine Zelle durchquert, mit einem zweiten Referenzstrom (I_{ref(0)}) zu vergleichen, der ein zweites Bit ausgibt, und
- eine Exklusiv-Oder-Funktion (260), um das erste Bit und das zweite Bit zu kombinieren und ein fehlerhaftes-Bit-Signal (Sx) auszugeben.

12. Speicher gemäß einem der Ansprüche 6 bis 11, wobei der erste Schwellenwert (I_{ref(1)}) und der zweite Schwellenwert (I_{ref(0)}) einen Bereich definieren, der den Bereich der leeren Zellen aufweist oder in dem Bereich der leeren Zellen enthalten ist, so dass der Fehlerzustand eines Bits über die Zeit stabil bleibt.
